# EUROPEAN PATENT APPLICATION

(11) **EP 4 832 737 A1**
(43) Date of publication of application: **28.10.2026**
(21) Application number: 26172681.4
(22) Date of filing: 16.04.2026
(51) Int. Cl.: H10W 40/77, H10W 40/00, H10W 40/20, H10W 40/22, H10W 40/25

(54) **DIE-TOP INTERCONNECTION IN DOUBLE-SIDED COOLED PACKAGE**

(30) Priority: 23.04.2025 US 202519187131
(71) Applicant: STMicroelectronics International N.V., 1228 Plan-les-Ouates, Geneva (CH)
(72) Inventor: YOO, Inpil, D-82008 Unterhaching (DE); PAUL, Indrajit, D-88677 Markdorf (DE); DIVAY, Valentin, D-85622 Feldkirchen (DE)
(74) Representative: Buzzi, Notaro & Antonielli d'Oulx S.p.A.

(57) **Abstract**

Provided is a double-sided cooled, DSC, package (100). The package includes a first structure (102) including a first interconnection layer (106), a first dielectric layer (108) formed on the first interconnection layer (106), a second interconnection layer (110) formed on the first dielectric layer (108), and a first substrate (112) formed on the second interconnection layer (110). The package (100) includes a second structure (104) including a third interconnection layer (114), a second dielectric layer (116) formed on the third interconnection layer (114), and a fourth interconnection layer (118) formed on the second dielectric layer (116). The package (100) includes at least one of a first spacer element (120) that contacts the first substrate (112) and the fourth interconnection layer (118), and a second spacer element (120) that contacts the second interconnection layer (110) and the fourth interconnection layer (118).

## Description

### BACKGROUND

### Technical Field

The present disclosure is directed to a double-sided cooled (DSC) package having die-top interconnection.

### Description of the Related Art

Conventional semiconductor packages are associated with reliability issues that stem from the use of solder to attach a heat channel on a substrate (e.g., die). The heat channel, which may be made of copper, copper molybdenum or AlSiC, and the solder have different coefficients of thermal expansion. The coefficient of thermal expansion mismatch between the two decreases the reliability of the channel and increases process yield losses.

### BRIEF SUMMARY

Provided is a double-sided cooled (DSC) package. The package includes a first structure including a first interconnection layer, a first dielectric layer formed on the first interconnection layer, a second interconnection layer formed on the first dielectric layer, and a first substrate formed on the second interconnection layer. The package includes a second structure including a third interconnection layer, a second dielectric layer formed on the third interconnection layer, and a fourth interconnection layer formed on the second dielectric layer. The package includes at least one of: a first spacer element that contacts the first substrate and the fourth interconnection layer, and a second spacer element that contacts the second interconnection layer and the fourth interconnection layer.

In an embodiment, the DSC package includes premold positioned between the first structure and the second structure, where the premold has at least one of: a first channel for passage of the first spacer element therethrough, and a second channel for passage of the second spacer element therethrough. In an embodiment, the package includes at least one of: a first ring positioned in the first channel and around the first spacer element, and a second ring positioned in the second channel and around the second spacer element. In an embodiment, at least one of the first ring and the second ring is made of copper.

In an embodiment, a surface of the first channel is treated to mitigate abrasions from the first spacer element. In an embodiment, a surface of the second channel is treated to mitigate abrasions from the second spacer element. In an embodiment, the surface of the first channel is treated by smoothing or surface coating. In an embodiment, the surface of the second channel is treated by smoothing or surface coating.

In an embodiment, at least one of the first spacer element and the second spacer element is made of copper foam and is compressed between the first structure and the second structure.

In an embodiment, at least one of the first spacer element and the second spacer element thermally conducts heat from the first structure to the second structure.

Provided is a converter including the DSC package.

Provided is a method including forming one or more premold portions having one or more channels therethrough, passing one or more spacer elements in the one or more channels, respectively, positioning the one or more premold portions and the one or more spacer elements between a first structure and a second structure, clamping the first structure and the second structure, and injecting mold between the first structure and the second structure.

In an embodiment, clamping the first structure and the second structure includes applying pressure on the first and second structures to compress the one or more spacer elements and cause the one or more spacer elements to contact both the first structure and the second structure.

In an embodiment, the method includes treating an interior surface of at least one channel of the one or more channels to mitigate abrasions from passage of a spacer element therethrough. In an embodiment, the method includes treating by smoothing or surface coating.

In an embodiment, the one or more spacer elements are made of copper foam.

In an embodiment, the method includes positioning one or more rings in the one or more channels, respectively, before passing the one or more spacer elements in the one or more channels, respectively. In an embodiment, the one or more rings are made of copper.

### BRIEF DESCRIPTION OF THE SEVERAL VIEWS OF THE DRAWINGS

Figure 1 shows a cross-sectional view of a DSC package.
Figure 2 shows a method of manufacturing the DSC package.
Figure 3A shows premold portions of the DSC package.
Figure 3B shows the premold portions of the DSC package having spacers passed therethrough.
Figure 3C shows the premold portions and the spacers between two structures of the DSC package.
Figure 3D shows mold clamping of the DSC package.
Figure 4 shows a block diagram of charging an electric vehicle.

### DETAILED DESCRIPTION

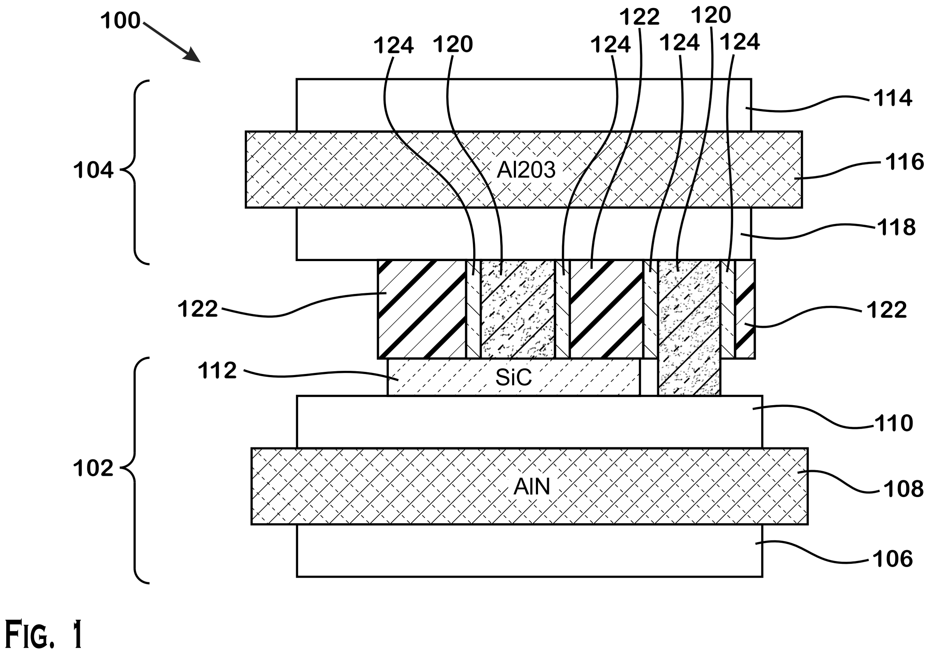

Figure 1 shows a cross-sectional view of a DSC package 100. The DSC package 100 has first and second structures 102, 104. The first and second structures 102, 104 may be positioned opposite each other. The first structure 102 may be a lower structure of the package 100 and the second structure 104 may be an upper structure of the package 100 in the double-sided configuration. Alternatively, the first structure 102 may be an upper structure and the second structure 104 may be a lower structure of the package 100 in the double-sided configuration.

The first structure 102 includes a first interconnection layer 106, a first dielectric layer 108 formed on the first interconnection layer 106, a second interconnection layer 110 formed on the first dielectric layer 108 and a substrate 112 formed on the second interconnection layer 110. The first and second interconnection layers 106, 110 may be copper wire bonding layers, aluminum wire bonding layers, or die soldering layers when the substrate 112 includes or receives a silicon die. The first and second interconnection layers 106, 110 may be clip soldering or die sintering layers when the substrate 112 includes or receives a silicon carbide (SiC) die. The first dielectric layer 108 may be composed of aluminum oxide (Al2O3) when the substrate 112 includes or receives a silicon die. The first dielectric layer 108 may be composed of aluminum nitride (AlN) when the substrate 112 includes or receives a silicon carbide (SiC) die.

Die soldering uses solder (such as, tin-lead (Sn-Pb), tin-silver-copper (Sn-Ag-Cu), or eutectic gold-tin (Au-Sn), among others) to connect the first substrate 112 to the second interconnection layer 110. Wire bonding uses aluminum or copper wires to electrically connect the first substrate 112 to the second interconnection layer 110. Die soldering and wire bonding may also be used in the first and second interconnection layers 106, 110.

Clip soldering and die sintering have higher reliability than die soldering and wire bonding. Clip soldering uses thicker copper or silver clips instead of thin wires. The clips have a lower resistance and carry more current than their wire counterparts. Clip soldering is associated with an improved thermal performance and reliability than wire bonding and die soldering. Die sintering uses sintered materials to connect the first substrate 112. Die sintering allows for improved thermal conductivity, electrical performance and mechanical robustness as compared to wire bonding and die soldering.

The second structure 104 includes a third interconnection layer 114, a second dielectric layer 116 formed on the third interconnection layer 114 and a fourth interconnection layer 118 formed on the second dielectric layer 116. The third and fourth interconnection layers 114, 118 may be copper wire bonding layers, aluminum wire bonding layers, or die soldering layers. The second dielectric layer 116 may be composed of aluminum oxide (Al2O3).

The first substrate 112 may dissipate heat in the package 100. The first and second dielectric layers 108, 116 have thermal isolation and heat dissipation capabilities. For example, AlN has a thermal conductivity of 120-170 watts per meter Kelvin (W/m·K) and Al2O3 has a thermal conductivity of 25 W/m·K. Further, AlN has a coefficient of thermal expansion of 4.5*10⁻⁶ C° and Al2O3 has a coefficient of thermal expansion of 8.1*10⁻⁶ C°.

Heat dissipated from the first substrate 112 may flow to both the first and second structures 102, 104. To facilitate heat dissipation from the first substrate 112 to the second structure one or more spacer elements 120 are positioned between the first and second structures 102, 104. A spacer element 120 may be positioned between the first substrate 112 and the fourth interconnection layer 118, between the second and fourth interconnection layers 110, 118 or both.

A spacer element 120 may be made of copper foam (or foamed copper or copper sponge). Copper foam is a rigid three-dimensional network of interconnected copper ligaments having open pores. Copper foam may have a Modulus of Elasticity (Compression) of 107 megapascal (MPa), a Modulus of Elasticity (Tension) of 101 MPa and a Shear Modulus of 282 MPa. In contrast, copper has a Modulus of Elasticity (Compression) of 117 gigapascal (GPa) and a Shear Modulus of 48 GPa.

The spacer element 120 may be positioned between premold portions 122. The premold portions 122 may be epoxy. The premold portions 122 may have surfaces that are smoothed to mitigate abrasions from the spacer element 120 or the passage of the spacer element 120 therethrough. Additionally or alternatively, rings 124 (or tubes) may be positioned between the premold portions 122 and the spacer elements 120. The rings 124 may be made of copper. The rings 124 may protect the premold portions 122 from abrasions resulting from the spacer elements or compression or passage thereof.

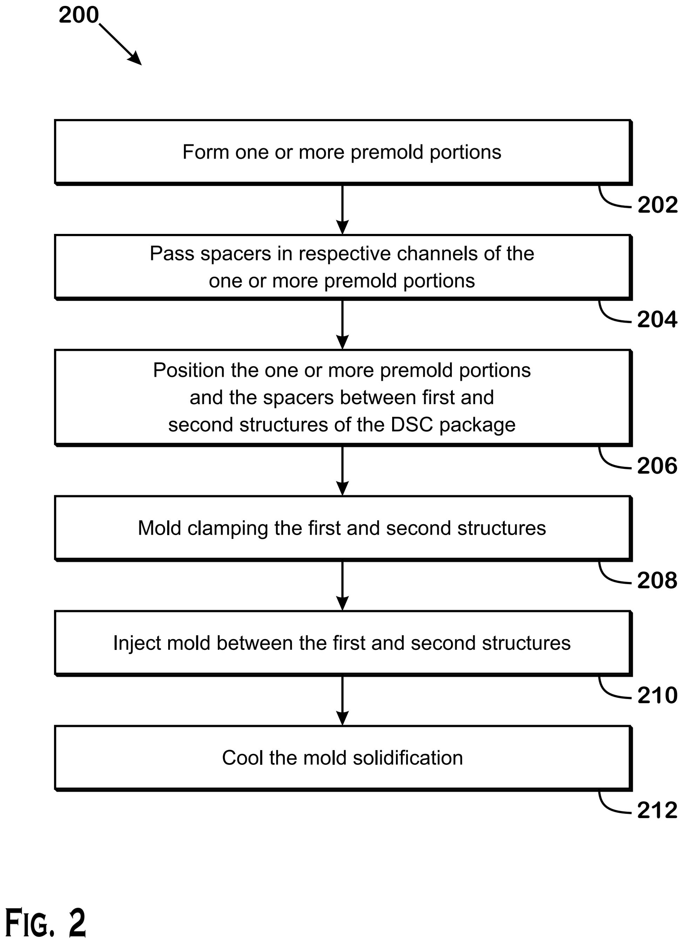

Figure 2 shows a method 200 of manufacturing a DSC package 100. The method includes forming, at 202, one or more premold portions. The one or more premold portions may be made from epoxy or a resin. The one or more premold portions may be sized and dimensioned to receive one or more spacer elements as described herein. The one or more premold portions may have one or more channels for receiving one or more spacer elements, respectively. The surfaces (e.g., interior surfaces) of the channels of the one or more premold portions may be treated (e.g., smoothed or surface coated) to reduce abrasions or damage from the thermal expansion of a spacer element, the application of pressure to the spacer element or expansion of the spacer element. Additionally or alternatively, a channel of a premold portion may include a ring that defines (or surrounds) the channel.

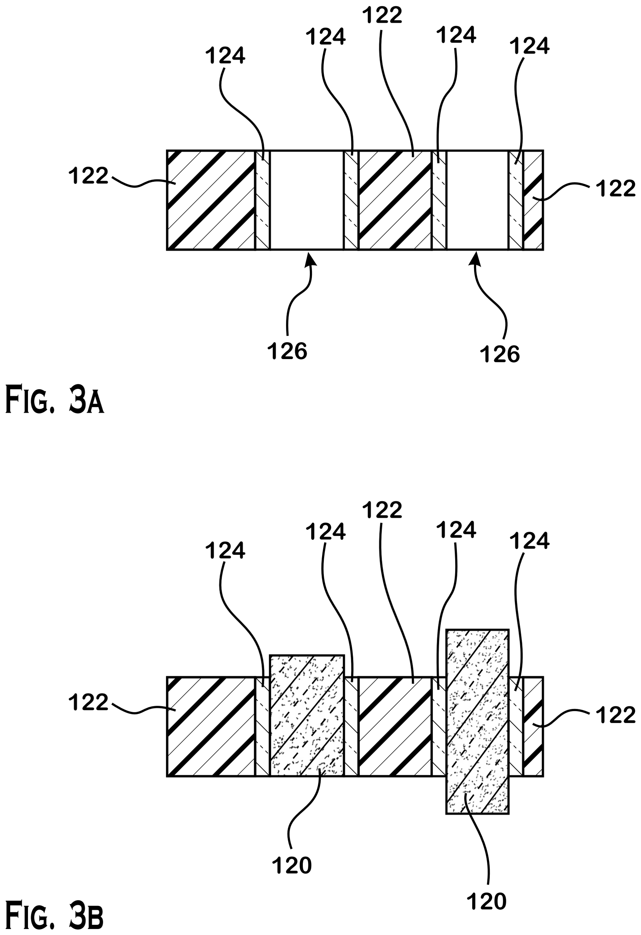

Figure 3A shows the premold portions 122 of the DSC package 100. The premold portions 122 have channels 126 for receiving respective spacer elements. In addition, each channel 126 is defined (or surrounded) by a ring 124. The ring 124 aids in mitigating abrasions (or other damage) to a premold portion 122 when a spacer is inserted in (or passed through) a channel 126.

Referring back to Figure 2, after forming the one or more premold portions, the method includes passing, at 204, spacers in respective channels of the one or more premold portions. Figure 3B shows the premold portions 122 of the DSC package 100 having spacers 120 passed therethrough. As described herein, the spacers 120 may be copper foam. The application of pressure to the spacers 120 may result in compressing the spacers 120. Because the spacers 120 may be compressed, a height of each spacer when passed through a respective channel 126 may be greater than the post-compression height of the spacer in the manufactured package.

Referring back to Figure 2, the method includes positioning, at 206, the one or more premold portions and the spacers between first and second structures of the DSC package. The first and second structures of the DSC package may be the first and second structures 102, 104 described herein with reference to Figure 1.

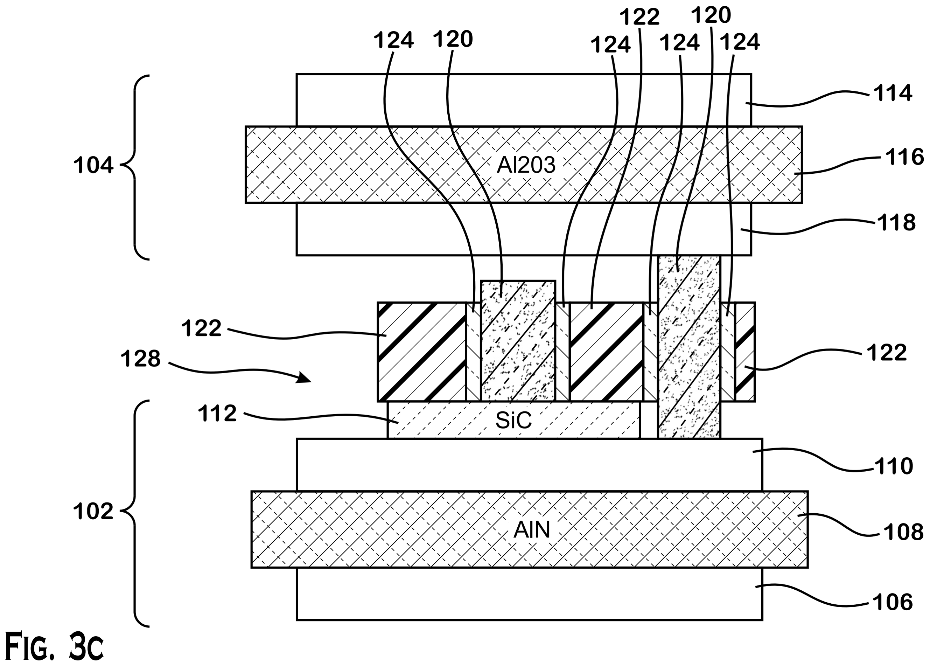

Figure 3C shows the one or more premold portions 122 and the spacers 120 between two structures 102, 104 of the DSC package 100. The spacers 120 may be cylinders. The oval or circular surfaces of one or more spacers 120 may contact one or both of the first and second structures 102, 104. As shown in Figure 3C, a first spacer contacts the first structure 102 and a second spacer contacts both the first and second structures 102, 104. In particular, the second spacer contacts both the second interconnection layer 110 of the first structure 102 and the fourth interconnection layer 118 of the second structure 104, and the first spacer contacts the substrate 112 of the first structure 102. Before mold clamping and before the application of pressure to the first and second structures 102, 104, the height of the second spacer prevents the first spacer from contacting the second structure 104.

Referring back to Figure 2, the method includes mold clamping, at 208, the first and second structures 102, 104. After mold clamping, the method includes injecting, at 210, mold 128 between the first and second structures 102, 104. After the mold 128 is injected, the method includes cooling, at 212, for mold solidification.

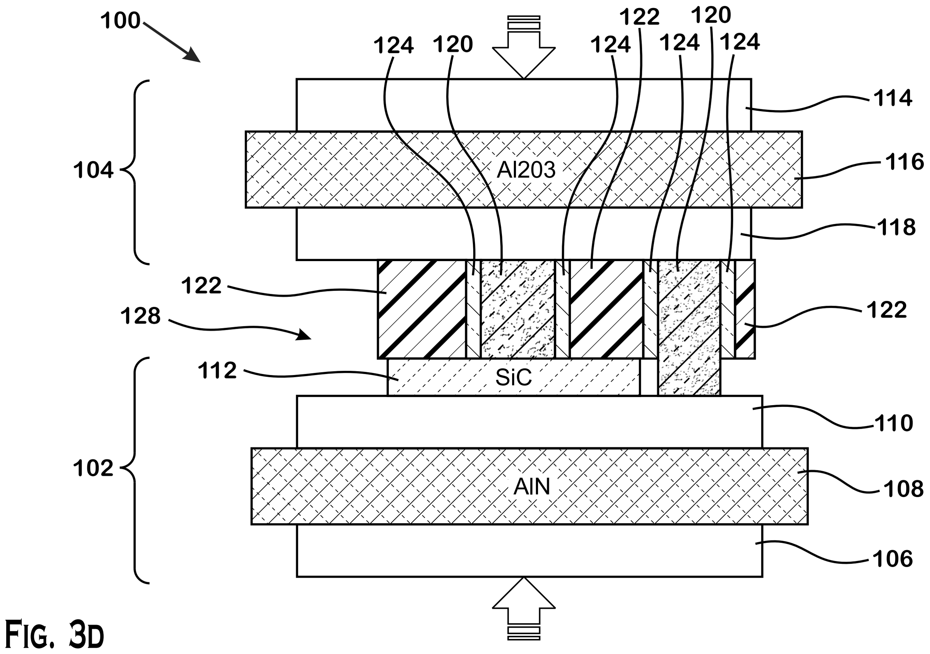

Figure 3D shows mold clamping of the DSC package 100. Mold clamping may include applying pressure to the first and second structures 102, 104 to secure the first and second structures 102, 104 in place for mold injection. The application of pressure results in compressing the spacers 120 such that each spacer 120 of the package 100 contacts both first and second structures 102, 104. It is noted that copper foam is more elastic than copper. Copper foam is a flexible material and can expand, shrink and absorb stress. The application of pressure by mold clamping compresses the spacers 120 and aids in ensuring that the spacers 120 contact both structures 102, 104 for thermal conduction.

The first structure 102 includes a substrate die. One or more spacers 120 may be positioned atop the substrate die. The spacers 120 operate as a thermal channel and thermally conduct heat emitted by the semiconductor die to the second structure 104. Accordingly, the DSC package 100 makes use of both the first dielectric layer 108 of the first structure 102 and the second dielectric layer 116 of the second structure 104 for heat dissipation.

The use of spacers 120 for die-top interconnection as described herein is advantageous in that it takes advantage of the mold clamping process step (for establishing a heat dissipation connection) without adding additional soldering process steps. For example, the one or more premold portions and the spacers may be positioned between the first and second structures as part of preparation for mold clamping the first and second structures.

The use of spacers 120 as described herein also forgoes the interconnection process steps and the reliability issues of conventional die-top attachment techniques. Conventional techniques for heat management employ two interconnection processes. For example, one interconnection process attaches a heat conductor (such as copper, copper molybdenum or AlSiC) to the top structure and another interconnection process attaches the conductor to the bottom structure. The techniques described herein forgo the interconnection processes because the spacer is connected to the structures by the application of pressure (e.g., a push interconnection), not soldering (e.g., a rigid interconnection). The techniques described herein also use less expensive materials (such as copper molybdenum or AlSiC).

Additionally, the techniques described herein improve the reliability of the package. The solder used in the interconnection processes of the copper, copper molybdenum or AlSiC is prone to degradation due to the mismatch in the thermal expansion coefficients of the solder on the one hand and the copper, copper molybdenum or AlSiC on the other hand. Consequently, the use of solder is associated with relatively high yield losses. In the techniques described herein, a die-top interconnection is made without reflow soldering and without sintering.

The DSC package 100 may be used in the power modules of an electric vehicle. For example, the DSC package 100 may be used in a traction inverter that converts DC power supplied from a battery to AC power to be provided to a motor. Further, the DSC package 100 may be used in the on-board charger of the vehicle and its DC-DC converters.

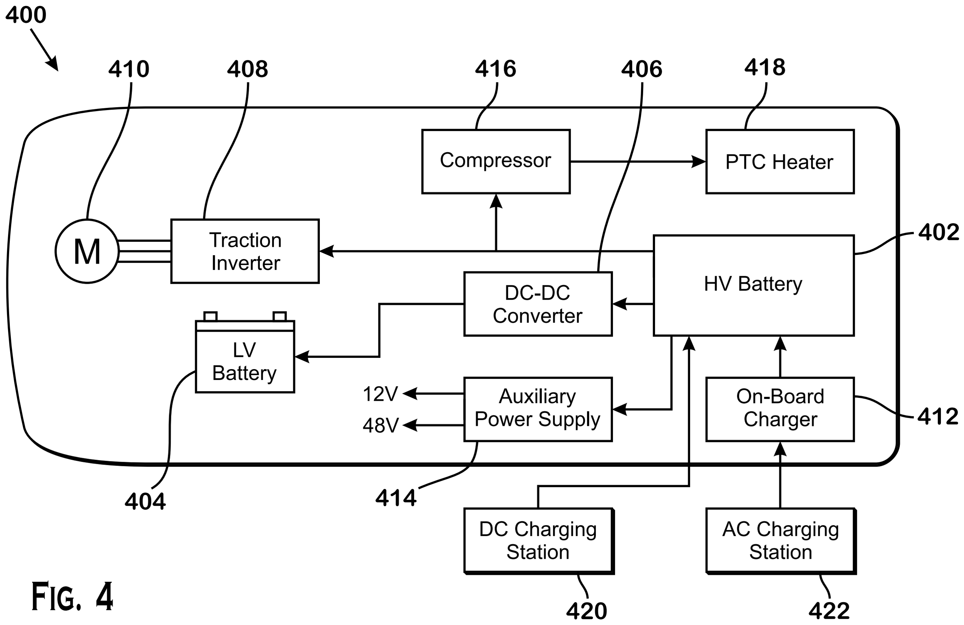

Figure 4 shows a block diagram of charging an electric vehicle 400. The electric vehicle 400 includes a high voltage (HV) battery 402. The HV battery 402 may be a DC battery and may have a voltage between 400 and 800 volts (V). The electric vehicle 400 includes a low voltage (LV) battery 404. The LV battery 404 may be a DC battery and may have a voltage that is lower than the voltage of the HV battery 402. The electric vehicle 400 includes a DC-DC converter 406, a traction inverter 408, a motor 410, an on-board charger 412, an auxiliary power supply 414, a compressor 416 and a heater 418. The motor may be an AC motor.

The electric vehicle 400 may be connected to a DC charging station 420 and an AC charging station 422. For example, the DC charging station 420 may be a fast DC charger. Each station 420, 422 may include a cable and a connector that is couplable to a respective vehicle inlet on the electric vehicle 400.

In the electric vehicle 400, the on-board charger 412 receives power from the AC charging station 422. The on-board charger 412 supplies the received power to the HV battery 402. The HV battery 402 also receives power directly from the DC charging station 420. The HV battery 402 stores the received power. The HV battery 402 is coupled to the DC-DC converter 406, the traction inverter 408 and the auxiliary power supply 414. The HV battery 402 supplies the stored power to the DC-DC converter 406, the traction inverter 408 and the auxiliary power supply 414.

The DC-DC converter 406 is coupled to the LV battery 404. The DC-DC converter 406 converts DC voltage received from the HV battery 402 to a lower voltage and supplies the lower voltage to the LV battery 404.

The traction inverter 408 is coupled to the motor 410. The traction inverter 408 inverts the DC voltage received from the HV battery 402 and generates AC voltage. The traction inverter 408 supplies the AC voltage to the motor 410. The auxiliary power supply 414 is coupled to the HV battery 402. The auxiliary power supply 414 may supply a lower DC voltage (such as, 12V and 48V) to components and outlets of the vehicle 400. The HV battery 402 also supplies DC power to the compressor 416. The compressor 416 drives the Positive Temperature Coefficient (PTC) heater 418.

The circuits of the high-voltage to low-voltage DC-DC converter 406, the traction inverter 408 and the on-board charger 412 may each include a power module. The power module of each inverter/converter may include the DSC package 100 described herein. For example, the DSC package 100 may be used to perform the control and switching that operates the low voltage DC-DC converter 406, the traction inverter 408 or the on-board charger 412.

The various embodiments described above can be combined to provide further embodiments. Aspects of the embodiments can be modified, if necessary to employ concepts of the various patents, applications and publications to provide yet further embodiments. These and other changes can be made to the embodiments in light of the above-detailed description. In general, in the following claims, the terms used should not be construed to limit the claims to the specific embodiments disclosed in the specification and the claims, but should be construed to include all possible embodiments along with the full scope of equivalents to which such claims are entitled. Accordingly, the claims are not limited by the disclosure.

## Claims

1. A double-sided cooled, DSC, package (100), comprising:
a first structure (102) including:
a first interconnection layer (106);
a first dielectric layer (108) formed on the first interconnection layer (106);
a second interconnection layer (110) formed on the first dielectric layer (108); and
a first substrate (112) formed on the second interconnection layer (110); and
a second structure (104) including:
a third interconnection layer (114);
a second dielectric layer (116) formed on the third interconnection layer (114); and
a fourth interconnection layer (118) formed on the second dielectric layer (116); and
wherein the DSC package (100) further comprises at least one of:
a first spacer element (120) that contacts the first substrate (112) and the fourth interconnection layer (118); and
a second spacer element (120) that contacts the second interconnection layer (110) and the fourth interconnection layer (118).

2. The DSC package (100) of claim 1, comprising:
premold (122) positioned between the first structure (102) and the second structure (104),
wherein the premold (122) has at least one of:
a first channel (126) for passage of the first spacer element (120) therethrough; and
a second channel (126) for passage of the second spacer element (120) therethrough.

3. The DSC package (100) of claim 2, comprising at least one of:
a first ring (124) positioned in the first channel (126) and around the first spacer element (120); and
a second ring (124) positioned in the second channel (126) and around the second spacer element (120).

4. The DSC package (100) of claim 3, wherein at least one of the first ring (124) and the second ring (124) is made of copper.

5. The DSC package (100) of any of claims 2 to 4, wherein a surface of the first channel (126) is treated to mitigate abrasions from the first spacer element (120), and/or a surface of the second channel (126) is treated to mitigate abrasions from the second spacer element (120).

6. The DSC package (100) of claim 5, wherein the surface of the first channel (126) is treated by smoothing or surface coating, and/or the surface of the second channel (126) is treated by smoothing or surface coating.

7. The DSC package (100) of any of the previous claims, wherein at least one of the first spacer element (120) and the second spacer element (120) is made of copper foam and is compressed between the first structure (102) and the second structure (104).

8. The DSC package (100) of any of the previous claims, wherein at least one of the first spacer element (120) and the second spacer element (120) thermally conducts heat from the first structure (102) to the second structure (104).

9. A converter (406; 408; 412), comprising:
a DSC package (100) according to any of the previous claims.

10. A method (200), comprising:
forming (202) one or more premold portions (122) having one or more channels (126) therethrough;
passing (204) one or more spacer elements (120) in the one or more channels (126), respectively;
positioning (206) the one or more premold portions (122) and the one or more spacer elements (120) between a first structure (102) and a second structure (104);
clamping (208) the first structure (102) and the second structure (104); and
injecting mold (210) between the first structure (102) and the second structure (104).

11. The method (200) of claim 10, wherein clamping (208) the first structure (102) and the second structure (104) includes applying pressure on the first and second structures to compress the one or more spacer elements (120) and cause the one or more spacer elements (120) to contact both the first structure (102) and the second structure (104).

12. The method (200) of claim 10 or claim 11, comprising:
treating an interior surface of at least one channel of the one or more channels (126) to mitigate abrasions from passage of a spacer element (120) therethrough.

13. The method (200) of claim 12, comprising:
treating the interior surface of at least one channel of the one or more channels (126) by smoothing or surface coating.

14. The method (200) of any of claims 10 to 13, wherein the one or more spacer elements (120) are made of copper foam.

15. The method (200) of any of claims 10 to 14, comprising:
positioning one or more rings (124) in the one or more channels (126), respectively, before passing (204) the one or more spacer elements (120) in the one or more channels (126), respectively;
wherein the one or more rings (124) are preferably made of copper.
